# EUROPÄISCHE PATENTSCHRIFT

(11) **EP 2 976 930 B1**
(45) Veröffentlichungstag und Bekanntmachung des Hinweises auf die Patenterteilung: **10.04.2019**
(21) Anmeldenummer: 14707718.4
(22) Anmeldetag: 26.02.2014
(51) Int. Cl.: H05K 7/14

(54) **STEUERGERÄT FÜR EIN KRAFTFAHRZEUG MIT EINER BERÜHRSCHUTZABDECKUNG**
CONTROL UNIT FOR A MOTOR VEHICLE WITH A SHOCK HAZARD PROTECTION COVER
CONTRÔLEUR POUR VÉHICULE AUTOMOBILE MUNI D'UN CAPOTAGE DE PROTECTION CONTRE LES CONTACTS

(30) Priorität: 18.03.2013 DE 102013204673
(43) Veröffentlichungstag der Anmeldung: 27.01.2016
(73) Patentinhaber: Robert Bosch GmbH, 70442 Stuttgart (DE)
(72) Erfinder: TEUSCH, Stefan, 72764 Reutlingen (DE)
(86) Internationale Anmeldenummer: PCT/EP2014/053672
(87) Internationale Veröffentlichungsnummer: WO 2014/146873

(56) Entgegenhaltungen:
- EP-A2- 1 197 397
- DE-A1-102005 015 318
- DE-A1-102011 004 625

## Beschreibung

### Stand der Technik

Die Erfindung betrifft ein Steuergerät für ein Elektrofahrzeug oder Hybridfahrzeug. Das Steuergerät weist ein Gehäuse auf, welches einen Hohlraum umschließt. Das Gehäuse weist einen Gehäusedeckel und eine Gehäuseöffnung auf, wobei der Gehäusedeckel ausgebildet ist, die Gehäuseöffnung zu verschließen. Das Hybridfahrzeug weist wenigstens eine elektrische Maschine und zusätzlich eine Verbrennungsmaschine auf.

Bei aus dem Stand der Technik bekannten Steuergeräten besteht das Problem, dass bei einem Öffnen des Gehäusedeckels des Gehäuses spannungsführende Teile im Inneren des Gehäuses berührt werden können, und so eine Person, die das Gehäuse öffnet, gefährdet werden kann.

Ein Steuergerät mit einer Berührschutzabdeckung ist aus DE 10 2011 004625 A1 bekannt.

### Offenbarung der Erfindung

Erfindungsgemäß weist das Steuergerät der eingangs genannten Art eine elektrisch isolierende Berührschutzabdeckung auf, welche wenigstens einen Vorsprungsbereich aufweist, welcher sich quer zu einer Oberfläche der Berührschutzabdeckung erstreckt. Der Gehäusedeckel weist wenigstens eine Aufnahme, insbesondere eine Aussparung oder eine Klemme für den Vorsprungsbereich auf, wobei die Aussparung ausgebildet ist, den Vorsprungsbereich kraftschlüssig festzuhalten.

Die Berührschutzabdeckung weist wenigstens einen Rasthaken auf, welcher ausgebildet ist, mit dem Gehäuse formschlüssig, oder zusätzlich kraftschlüssig zu verrasten. Weiterhin ist eine Kraft zum Lösen der Verrastung der Berührschutzabdeckung mit dem Gehäuse größer als eine Kraft zum Trennen der Berührschutzabdeckung von dem Gehäusedeckel.

So kann der Gehäusedeckel zusammen mit der Berührschutzabdeckung vorteilhaft mit dem Gehäuseteil verbunden werden, und beim Öffnen des Gehäusedeckels der Vorsprungsbereich von dem Gehäusedeckel getrennt werden, wobei die Berührschutzabdeckung mit dem Gehäuse oder dem Teil des Steuergeräts im Inneren des Gehäuses verrastet bleiben kann. Weiter vorteilhaft kann so die Berührschutzabdeckung in einem Fertigungsschritt mit dem Gehäusedeckel verbunden werden

Während einer Montage des Steuergeräts kann der Gehäusedeckel zusammen mit der Berührschutzabdeckung montiert werden, und ist so bereits in einer vorbestimmten Position mit dem Gehäusedeckel verbunden. Wenn das Steuergerätegehäuse - beispielsweise zu Wartungs- oder Servicezwecken - geöffnet werden soll, so kann dazu der Gehäusedeckel von dem Gehäuse getrennt, oder aufgeklappt werden. Während des Trennens oder Aufklappens kann sich der Gehäusedeckel von der Berührschutzabdeckung lösen, insoweit die Berührschutzabdeckung mittels der kraftschlüssigen Verbindung mit dem Gehäusedeckel schwächer verbunden ist, als mittels der formschlüssigen Verbindung mit dem Gehäuse, oder dem Teil des Steuergeräts im Inneren des Gehäuses. Die Berührschutzabdeckung bleibt so mit dem Steuergerät verbunden, und kann spannungsführende elektrische Komponenten, welche von der Berührschutzabdeckung verdeckt werden, vor einem unbeabsichtigten Berühren verbergen.

Das Steuergerät ist bevorzugt ausgebildet, eine elektrische Maschine zum Fortbewegen des Elektrofahrzeugs oder Hybridfahrzeugs im Motorbertrieb und/oder im Generatorbertrieb anzusteuern und mit der elektrischen Maschine verbunden zu werden. Dazu weist das Steuergerät bevorzugt einen Anschluss für die elektrische Maschine auf. Weiter bevorzugt weist das Steuergerät einen Wechselrichter, insbesondere Hochvolt-Wechselrichter zum Bestromen der elektrischen Maschine auf. Der Hochvolt-Wechselrichter ist ausgebildet, eine Spannung vom mehr als 60 Volt, bevorzugt mehr als 400 Volt, weiter bevorzugt zwischen 400 und 1500 Volt auf einen Ausgangsanschluss für die elektrische Maschine zu schalten.

Bevorzugt ist das Steuergerät ausgebildet, einen Klimakompressor, und/oder eine elektrische Heizung anzusteuern und mit Betriebsspannung zu versorgen. Dazu weist das Steuergerät einen elektrischen Anschluss für den Klimakompressor und/oder die Heizung auf.

Bevorzugt ist die Berührschutzabdeckung ausgebildet, wenigstens einen Anschluss, insbesondere wenigstens einen der Anschlüsse für die elektrische Maschine oder den Klimakompressor oder die Heizung, abzudecken.

In einer bevorzugten Ausführungsform weist die Berührschutzabdeckung eine an die Berührschutzabdeckung angeformte, elastisch ausgebildete Dichtung auf. Die Dichtung ist ausgebildet, wenigstens einen Rand der Gehäuseöffnung, und den Gehäusedeckel einander abzudichten. Bevorzugt ist die Dichtung an die Berührschutzabdeckung angespritzt. Die Dichtung ist bevorzugt durch ein Elastomer, weiter bevorzugt durch einen Silikongummi, gebildet. Durch die Dichtung kann vorteilhaft keine Feuchtigkeit in das Gehäuse eindringen.

Bevorzugt ist die Dichtung ausgebildet, über einen Rand des Gehäusedeckels hinauszuragen. In einer anderen Ausführungsform weist der Gehäusedeckel im Bereich eines Gehäusedeckelrandes eine bis hin zur Dichtung reichende Aussparung auf. So kann die Dichtung vorteilhaft von außen gesehen werden, und ein Vorhandensein der Berührschutzabdeckung kontrolliert werden.

In einer bevorzugten Ausführungsform weist der Gehäusedeckel wenigstens einen Durchbruch, oder eine Aussparung für eine Schraube auf. Das Gehäuse weist bevorzugt ein Gewinde, insbesondere ein Innengewinde für die Schraube auf, wobei das Innengewinde derart angeordnet ist, dass der Gehäusedeckel mit dem Gehäuse dicht verschraubt werden kann.

So kann der Gehäusedeckel mit dem Gehäuse trennbar verbunden sein, so dass elektrische Komponenten zu Wartungszwecken von außen zugänglich sind. Bevorzugt ist der Gehäusedeckel mittels eines Scharniers mit dem Gehäuse verbunden, so dass der Gehäusedeckel aufgeklappt werden kann. Das Scharnier kann beispielsweise als Rastscharnier ausgebildet sein, welches ausgebildet ist, dass der Gehäusedeckel bei einem erstmaligen Verbinden mit dem Gehäuse mit dem Gehäuse formschlüssig verbunden werden kann, und bei einem Öffnen nach dem Verbinden mit dem Gehäuse über das Scharnier verbunden bleibt.

In einer bevorzugten Ausführungsform weist die Berührschutzabdeckung wenigstens einen Durchbruch zum Durchführen einer Tastspitze eines elektrischen Spannungsmessgerätes auf. Bevorzugt umfasst das Steuergerät wenigstens eine elektrische Komponente, die zum Führen von Hochspannung ausgebildet ist. Bevorzugt ist die elektrische Komponente in dem von dem Gehäuse umschlossenen Hohlraum angeordnet. Bevorzugt ist die Berührschutzabdeckung ausgebildet, die elektrische Komponente derart abzudecken, dass die elektrische Komponente durch die Gehäuseöffnung nicht berührt werden kann.

Der Durchbruch zum Durchführen der Tastspitze weist beispielsweise einen Durchmesser zwischen zwei und fünf Millimeter auf.

Durch den Durchbruch kann vorteilhaft nach einem Öffnen des Gehäusedeckels geprüft werden, ob die elektrische Komponente spannungsführend ist. Nach dem Prüfen kann dann die Berührschutzabdeckung durch Lösen der Verrastung entfernt werden, sodass die elektrische Komponente zu Wartungs- oder Servicezwecken durch die Gehäuseöffnung hindurch zugänglich ist.

In einer bevorzugten Ausführungsform ist an die Berührschutzabdeckung ein Halteelement angeformt, welches sich quer zu der Oberfläche in eine zum Vorsprungsbereich entgegengesetzte Richtung erstreckt. Bevorzugt ist das Halteelement hohlzylinderabschnittsförmig oder hohlzylinderförmig geformt. Das Halteelement ist ausgebildet, einen Kopf einer Schraube, insbesondere einer Sechskantschraube, zu umgreifen und gegen ein Lösen der Schraube festzuhalten. Bevorzugt ist mittels der Schraube eine zuvor erwähnte elektrische Komponente gebildet.

Bevorzugt ist die Schraube Bestandteil eines elektrischen Anschlusses zum Verbinden des Steuergeräts, wobei der elektrische Anschluss ausgebildet ist, mit einem Kabelschuh eines elektrischen Anschlusskabels befestigt zu werden. Dazu weist der elektrische Anschluss die zuvor erwähnte Schraube auf, welche von dem Halteelement gegen ein Lösen festgehalten werden kann.

Die zuvor erwähnte Zylinderwand kann beispielsweise Einschnitte in Richtung einer Längserstreckung des Hohlzylinders aufweisen, sodass so gebildete Zylinderwandsegmente, welche durch die Einschnitte voneinander getrennt sind, den Schraubenkopf federnd festhalten können.

Bevorzugt ist die Berührschutzabdeckung aus insbesondere faserverstärktem Kunststoff gebildet. Bevorzugt weist der Kunststoff der Berührschutzabdeckung Poly-Butylen-Therephthalat auf. Die zuvor erwähnte Dichtung ist bevorzugt an die Berührschutzabdeckung angespritzt, und ist beispielsweise aus Liquid-Silicon-Rubber gebildet.

Die Erfindung betrifft auch ein Verfahren zum Absichern eines Steuergerätes, insbesondere ein Steuergerät der vorbeschriebenen Art, umfassend ein einen Hohlraum umschließendes Gehäuse, umfassend die Schritte:
- kraftschlüssiges Verbinden einer Berührschutzabdeckung mit einer Innenwand eines Gehäusedeckels;
- Verschließen einer Gehäuseöffnung des Gehäuses mit dem Gehäusedeckel, wobei die Berührschutzabdeckung mit dem Gehäuse oder einem - bevorzugt in dem Hohlraum aufgenommenen - mit dem Gehäuse verbundenen Teil des Steuergeräts verrastet, so dass die Berührschutzabdeckung mit dem Gehäuse oder Teil formschlüssig verbunden ist,
wobei eine Kraft zum Lösen der Verrastung der Berührschutzabdeckung mit dem Gehäuse größer als eine Kraft zum Trennen der Berührschutzabdeckung von dem Gehäusedeckel ist.

Bevorzugt wird bei dem Verfahren beim Verschließen der Gehäuseöffnung eine an die Berührschutzabdeckung angeformte Dichtung zwischen einem Öffnungsrand der Gehäuseöffnung und dem Gehäusedeckel eingeschlossen, so dass der Hohlraum vor eindringender Feuchtigkeit geschützt ist.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt schematisch ein Steuergerät in einer Schnittdarstellung, bei dem elektrische Anschlüsse durch eine Gehäuseöffnung zugänglich sind und von einer Berührschutzabdeckung verdeckt sind;
Figur 2 zeigt das in Figur 1 gezeigte Steuergerät, bei dem der Gehäusedeckel entfernt worden ist, wobei die Berührschutzabdeckung sich vom Gehäusedeckel getrennt hat und mit dem Steuergerät verbunden, insbesondere verrastet bleibt;
Figur 3 zeigt die in Figur 1 gezeigte Berührschutzabdeckung in einer Aufsicht.

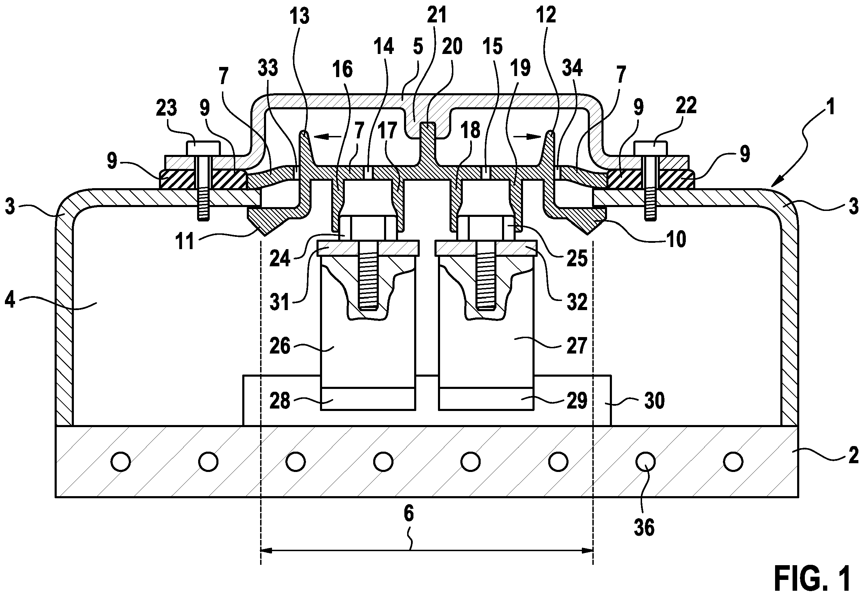

Figur 1 zeigt ein Ausführungsbeispiel für ein Steuergerät 1 für ein Kraftfahrzeug. Das Steuergerät 1 weist ein Gehäuse 3 auf, welches einen Hohlraum 4 umschließt. Das Gehäuse 3 weist auch einen Gehäusedeckel 5 auf, welcher ausgebildet ist, eine Gehäuseöffnung 6 des Gehäuses 3 zu verschließen.

Der Hohlraum 4, welcher von dem Gehäuse 3 umschlossen ist, schließt an die Öffnung 6 des Gehäuses an, sodass in dem Gehäuse 3 angeordnete elektrische Komponenten von außen durch die Öffnung 6 erreicht werden können.

Das Steuergerät 1 weist in diesem Ausführungsbeispiel als elektrische Komponenten eine Leistungsendstufe 30 auf, welche in diesem Ausführungsbeispiel zwei Leistungshalbleiter 28 und 29, welche in diesem Ausführungsbeispiel jeweils als Leistungstransistor, insbesondere Feldeffekttransistor oder IGBT (IGBT = Insulated-Gate-Bipolar-Transistor) ausgebildet sind, aufweist.

Die Leistungsendstufe 30 weist einen elektrischen Anschluss 27, welcher mit dem Leistungstransistor 29 verbunden ist und einen elektrischen Anschluss 26 auf, welcher mit dem Leistungstransistor 28 verbunden ist. Der elektrische Anschluss 26 weist einen Schraubanschluss mit einer Schraube 24 auf, der elektrische Anschluss 27 weist einen Schraubanschluss mit einer Schraube 25 auf. Die Schraubanschlüsse 26 und 27 sind jeweils ausgebildet, einen Kabelschuh 31 mit der Schraube 24, beziehungsweise einen Kabelschuh 32 mit der Schraube 25, festzuklemmen und elektrisch zu kontaktieren.

Das Steuergerät 1 weist auch eine Berührschutzabdeckung 7 auf. Die Berührschutzabdeckung 7 ist in diesem Ausführungsbeispiel aus Kunststoff, insbesondere glasfaserverstärktem Poly-Butylen-Therephthalat, ABS-Kunststoff (ABS = Acrylnitril-Butadien-Styrol) oder einem aliphatischen Polyamid, insbesondere einem Polyamid gebildet aus Hexamethylendiamin und Adipinsäure, insbesondere auch als PA66 bekannt, gebildet.

Die Berührschutzabdeckung 7 weist eine einen Dichtungsrand 9 als Dichtung auf, welcher in diesem Ausführungsbeispiel an die Berührschutzabdeckung 7 angeformt ist. Der Dichtungsrand 9 ist in diesem Ausführungsbeispiel durch einen Silikongummi, insbesondere LSR gebildet. Der Dichtungsrand 9 ist ausgebildet, den Gehäusedeckel 5, insbesondere im Bereich eines Deckelrandes des Gehäusedeckels 5, gegen das Gehäuse 3 im Bereich eines Öffnungsrandes der Öffnung 6 abzudichten.

Die Dichtung 9 ragt im Bereich eines Deckelrandes des Gehäusedeckels über den Deckelrand hinaus, so dass das Vorhandensein der Berührschutzabdeckung von außen gesehen werden kann. Dazu weist die Dichtung beispielweise eine Signalfarbe, insbesondere eine der Farben Rot, Gelb oder Orange auf.

Das Steuergerät 1 weist in diesem Ausführungsbeispiel dazu eine Schraubverbindung auf, mit welcher der Gehäusedeckel 5 mit dem Gehäuse 3 verbunden werden kann. Dargestellt ist eine Schraube 23 und eine Schraube 22, welche jeweils ausgebildet sind, den Gehäusedeckel 5 mit dem Gehäuse 3 zu verbinden und den Gehäusedeckel 5 an das Gehäuse 3 im Bereich des Öffnungsrandes der Öffnung 6 anzupressen.

Der Gehäusedeckel 5 weist einen in Richtung des Hohlraums 4 weisenden Aufnahmebereich 21 mit einer Aussparung auf. Der Aufnahmebereich 21 ist ausgebildet, einen Vorsprungsbereich 20 kraftschlüssig festzuhalten, wobei der Vorsprungsbereich 20 an die Berührschutzabdeckung angeformt ist und sich von einer flachen Erstreckung der Berührschutzabdeckung 7 abweisend, dem Gehäusedeckel 5 entgegenstreckt.

Die Berührschutzabdeckung 7 weist in diesem Ausführungsbeispiel auch zwei Rasthaken 10 und 11 auf, welche sich jeweils in Richtung des Hohlraums 4 erstrecken und welche jeweils an die Berührschutzabdeckung 7 angeformt sind.

Die Berührschutzabdeckung 7 weist in diesem Ausführungsbeispiel auch einen Betätigungshebel 13 auf, welcher an die Berührschutzabdeckung 7 im Bereich des Rasthakens 11 angeordnet ist, und sich von der Berührschutzabdeckung 7 abweisend in Richtung Deckel 5 erstreckt. Die Berührschutzabdeckung 7 weist auch einen Betätigungshebel 12 auf, welcher sich in Richtung des Deckels 5 erstreckt und im Bereich des Rasthakens 10 an die Berührschutzabdeckung 7 angeformt ist. Die Berührschutzabdeckung 7 weist im Bereich der Betätigungshebel 13 und 12 jeweils einen Schlitz 33 beziehungsweise 34 auf, sodass die Betätigungshebel 13 und 12 federnd geschwenkt werden können. Die Berührschutzabdeckung 7 ist ausgebildet, beim Schwenken des Betätigungshebels 13 den Rasthaken 11 mitzuschwenken und beim Betätigen des Betätigungshebels 12 den Rasthaken 10 mitzuschwenken. Die Rasthaken 10 und 11 sind jeweils ausgebildet und angeordnet, den Rand der Gehäuseöffnung 6 formschlüssig zu hintergreifen. Nach einem Betätigen der Betätigungshebel werden die Rasthaken 10 und 11 jeweils von dem Öffnungsrand weggeschwenkt, sodass die Berührschutzabdeckung 7 von dem Gehäuse 3 entfernt werden kann. In einer anderen Ausführungsform weist die Berührschutzabdeckung keine Betätigungshebel auf, stattdessen ist der Rasthaken im Bereich eines Durchbruchs der Berührschutzabdeckung V-förmig oder U-förmig ausgebildet, wobei ein V-Schenkel oder U-Schenkel an die Berührschutzabdeckung unter Ausbildung eines federnden Schwenkgelenks angeformt ist. Der Rasthaken weist einen zum Hintergreifen des Gehäuseöffnungsrandes ausgebildeten Vorsprungsbereich auf, welcher an den U-Schenkel oder V-Schenkel von diesem abweisend angeformt ist. Der Rasthaken kann so beim Schließen der Berührschutzabdeckung mit dem Gehäuse verrasten. Zum Entfernen der Berührschutzabdeckung kann der Rasthaken durch Eingreifen mit einem Hebelwerkzeug, beispielsweise einem Schraubendreher, durch den Durchbruch und in die V-Form oder U-Form des Rasthakens hinein und durch Hebeln geschwenkt werden, so dass der Vorsprungsbereich die Berührschutzabdeckung freigeben kann.

Die Berührschutzabdeckung 7 weist eine Messöffnung 14 auf, welche im Bereich der Schraube 24 angeordnet ist. Die Berührschutzabdeckung 7 weist auch eine Messöffnung 15 auf, welche im Bereich der Schraube 25 angeordnet ist.

Die Funktion des Steuergerätes 1 wird nun im Folgenden beschrieben:
Zur Montage des Steuergerätes 1 können die elektrischen Anschlüsse 26 und 27 jeweils mit einem Kabelschuh 31, beziehungsweise 32 mittels der Schraube 24 beziehungsweise 25 verbunden werden. Die Kabelschuhe 31 und 32 können beispielsweise durch eine in Figur 1 nicht weiter dargestellte Gehäuseöffnung des Gehäuses 3 zu den elektrischen Anschlüssen 26 und 27 geführt werden.

Die Berührschutzabdeckung 7 kann mit dem Vorsprungsbereich 20, welcher in diesem Ausführungsbeispiel als Zapfen ausgebildet ist, mit dem Gehäusedeckel 5 durch Einführen des Zapfens 20 in die Aussparung des Aufnahmebereichs 21 des Gehäusedeckels 5 eingeführt werden und so mit dem Gehäusedeckel 5 verbunden werden. Nach dem Verbinden des Gehäusedeckels 5 mit der Berührschutzabdeckung 7 kann der Gehäusedeckel 5 zusammen mit der Berührschutzabdeckung 7 mit dem Gehäuse 3 verbunden werden und dabei die Gehäuseöffnung 6 verschließen.

Beim Verbinden des Gehäusedeckels 5 zusammen mit der Berührschutzabdeckung 7 mit den Gehäuse 3 rasten die Rasthaken 10 und 11 in die Gehäuseöffnung 6 ein und hintergreifen dabei jeweils den Gehäuserand im Bereich der Gehäuseöffnung 6.

An die Berührschutzabdeckung 7 ist in diesem Ausführungsbeispiel auch ein Halteelement 16 und ein Halteelement 17 angeordnet, welche jeweils als Hohlzylinderumfangsabschnitte ausgebildet sind und an die Berührschutzabdeckung 7 angeformt sind. Die Halteelemente 16 und 17 sind ausgebildet, die Schraube 24 festzuhalten und gegen ein Losdrehen zu sichern. Die Berührschutzabdeckung 7 weist auch zwei Halteelemente 18 und 19 auf, welche jeweils als Hohlzylinderumfangsabschnitte ausgebildet sind und gemeinsam die Schraube 25 festhalten können. Die Hohlzylinderumfangsabschnitte 16 und 17, wie auch die Hohlzylinderumfangsabschnitte 18 und 19, werden beim Verschließen der Gehäuseöffnung 6 jeweils an die Schrauben 24 und 25 herangeführt und umschließen in einer Endposition, in der die Rasthaken 10 und 11 jeweils einrasten, die Schraubenköpfe der Schrauben 24 beziehungsweise 25.

Der Gehäusedeckel 5 kann nach einem Verschließen der Gehäuseöffnung 6 des Gehäuses 3 mittels der Schrauben 23 und 22 fest verschlossen werden.

Dabei dichtet der umlaufende Dichtungsrand 9, den Spalt zwischen dem Deckel 5 und dem Gehäuse 3 gegen eindringende Feuchtigkeit ab.

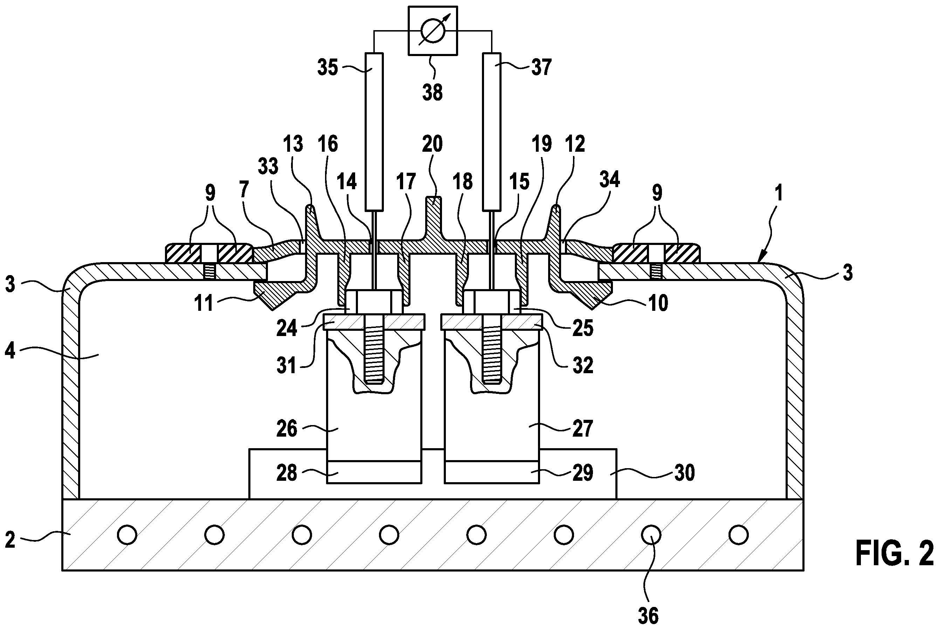

Figur 2 zeigt das in Figur 1 dargestellte Steuergerät, bei dem die Schrauben 22 und 23 jeweils gelöst und entfernt worden sind. Der in Figur 1 dargestellte Gehäusedeckel 5 ist in der in Figur 2 gezeigten Darstellung des Steuergerätes 2 ebenfalls entfernt worden. Die Berührschutzabdeckung 7 bleibt mittels der Rasthaken 10 und 11 mit dem Gehäuse 3 fest verbunden, wohingegen der mit dem Gehäusedeckel 5, insbesondere dem Aufnahmebereich 21, nur kraftschlüssig verbundene Vorsprungsbereich 20 beim Entfernen des Gehäusedeckels 5 von dem Gehäuse 3 von dem Aufnahmebereich 21 getrennt werden kann. Die Berührschutzabdeckung 7 verbleibt so vorteilhaft mit dem Gehäuse 3 verbunden, sodass die elektrischen Anschlüsse 26 und 27, welche beispielsweise mit einem Hochspannung führenden Kondensator verbunden sind, von außen nicht berührt werden können.

In einem weiteren Prüfschritt können in Figur 2 dargestellte Tastspitzen 35 und 37 eines Messgerätes 38 in die Messöffnung 14 beziehungsweise in die Messöffnung 15 eingeführt werden und dabei die Schraube 24, beziehungsweise die Schraube 25 berühren. Mittels des Messgerätes 38, beispielsweise eines Spannungsmessgerätes, kann so geprüft werden, ob die elektrischen Anschlüsse 26 und 27 jeweils spannungsführend sind.

Wenn die elektrischen Anschlüsse 26 und 27 jeweils hinreichend spannungslos sind, kann die Berührschutzabdeckung 7 durch Schwenken der Betätigungshebel 12 und 13 entfernt werden. Beim Schwenken der Betätigungshebel 12 und 13 werden die Rasthaken 11 beziehungsweise 10 mitgeschwenkt, sodass die Rasthaken 10 und 11 den Gehäuserand im geschwenkten Zustand nicht mehr formschlüssig hintergreifen. Die Berührschutzabdeckung 7 kann danach entfernt werden.

Nach einem Entfernen der Berührschutzabdeckung 7 können beispielsweise die Schrauben 24 und 25 gelöst werden, und nach einem Lösen der Schrauben 24 und 25 die Kabelschuhe 31 und 32 von den elektrischen Anschlüssen 26 und 27 getrennt werden.

Das Gehäuse 3 weist auch einen Gehäuseboden 2 auf, welcher zum Fluidführen ausgebildete Kanäle aufweist. Von den Kanälen ist der Kanal 36 beispielhaft bezeichnet. Die Leistungsendstufe 30 ist mit dem Gehäuseboden 2 wärmeleitend verbunden. Von der Leistungsendstufe 30 erzeugte Wärme kann so an den Gehäuseboden 2, welcher beispielsweise durch einen Metallblock, insbesondere Aluminiumblock, gebildet ist, aufgenommen werden. Die von dem Gehäuseboden 2 aufgenommene Wärme kann beispielsweise über ein in den Kanälen fließendes Fluid, insbesondere Kühlwasser, weiter abgeführt werden.

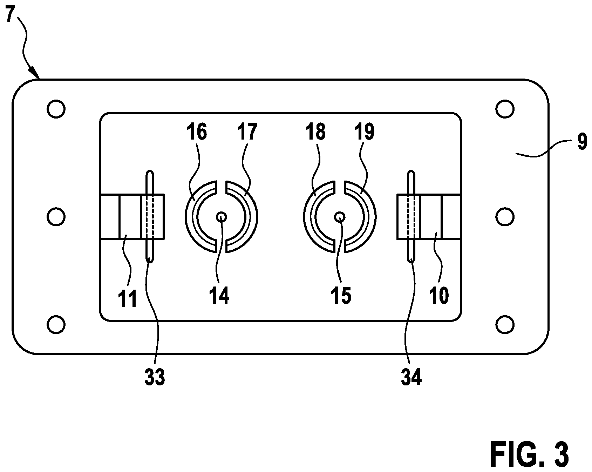

Figur 3 zeigt die in den Figuren 1 und 2 bereits dargestellte Berührschutzabdeckung 7 in einer Aufsicht. Dargestellt ist die als umlaufend ausgebildeter Dichtungsrand 9 ausgebildete Dichtung, welche an die Berührschutzabdeckung 7 angeformt ist. Dargestellt sind auch die Halteelemente 16 und 17, welche jeweils Segmente eines Hohlzylinders bilden. Die Halteelemente 18 und 19 bilden ebenfalls gemeinsam Segmente eines Hohlzylinders.

Die Halteelemente 16, 17, 18 und 19 sind jeweils an die Berührschutzabdeckung 7 angeformt, insbesondere angespritzt und erstrecken sich abweisend von einer flachen Erstreckung der Berührschutzabdeckung 7. Die Berührschutzabdeckung kann beispielsweise im Spritzgussverfahren hergestellt sein.

Dargestellt sind auch die Rasthaken 10 und 11, wobei die Berührschutzabdeckung 7 im Bereich der Rasthaken 10 und 11 sich jeweils längs erstreckende Schlitze 33 beziehungsweise 34 aufweist. Die Berührschutzabdeckung 7 kann so beim Betätigen der in Figur 1 dargestellten Betätigungshebel 13 und 12 im Bereich der Schlitze 33 beziehungsweise 34 einfedern. Die Rasthaken 11 und 10 können so geschwenkt werden, und den mittels der Rasthaken 10 und 11 gebildeten, in Figur 1 dargestellten formschlüssigen Hintergriff des Öffnungsrandes der Gehäuseöffnung 6 freigeben.

Die Messöffnung 14 ist in diesem Ausführungsbeispiel in einer Mitte des mittels der Halteelemente 16 und 17 gebildeten Hohlzylinders angeordnet. Die Messöffnung 15 ist diesem Ausführungsbeispiel in einer Mitte des durch die Halteelemente 18 und 19 ausgebildeten Hohlzylinders angeordnet. Dadurch kann die unter der Berührschutzabdeckung angeordnete Schraube getastet und eine von der Schraube geführte Spannung erfasst werden.

## Patentansprüche

1. Steuergerät (1) für ein Elektrofahrzeug oder Hybridfahrzeug mit einem wenigstens einen Hohlraum (4) umschließenden Gehäuse (3), wobei das Gehäuse (3) einen Gehäusedeckel (5) und eine Gehäuseöffnung (6) aufweist, wobei der Gehäusedeckel (5) ausgebildet ist, die Gehäuseöffnung (6) zu verschließen, wobei das Steuergerät (1) eine elektrisch isolierende Berührschutzabdeckung (7) aufweist,
wobei die elektrisch isolierende Berührschutzabdeckung (7) wenigstens einen Vorsprungsbereich (20) aufweist, welcher sich quer zu einer Oberfläche der Berührschutzabdeckung (7) erstreckt,
**gekennzeichnet dadurch, dass**
der Gehäusedeckel (5) wenigstens eine Aufnahme (21) für den Vorsprungsbereich (20) aufweist, welche ausgebildet ist, den Vorsprungsbereich (20) kraftschlüssig festzuhalten und die Berührschutzabdeckung (7) wenigstens einen Rasthaken (10, 11) aufweist, wobei der Rasthaken (10, 11) ausgebildet ist, mit dem Gehäuse (3) formschlüssig oder zusätzlich kraftschlüssig zu verrasten, wobei eine Kraft zum Lösen der Verrastung der Berührschutzabdeckung (7) mit dem Gehäuse (3) größer als eine Kraft zum Trennen der Berührschutzabdeckung (7) von dem Gehäusedeckel (5) ist,
so dass der Gehäusedeckel zusammen mit der Berührschutzabdeckung (7) mit dem Gehäuse (3) verbunden werden kann, und beim Öffnen des Gehäusedeckels (5) der Vorsprungsbereich (20) von dem Gehäusedeckel (5) getrennt werden kann, wobei die Berührschutzabdeckung (7) mit dem Gehäuse (3) verrastet bleiben kann.

2. Steuergerät (1) nach Anspruch 1,
**dadurch gekennzeichnet, dass**
an die Berührschutzabdeckung (7) ein Betätigungshebel (12, 13) angeformt ist, welcher sich von der Berührschutzabdeckung (7) abweisend in Richtung Deckel (5) erstreckt und die Berührschutzabdeckung (7) im Bereich des Betätigungshebels (12, 13) einen Schlitz (33, 34) aufweist, sodass der Betätigungshebel (12, 13) federnd geschwenkt werden kann, wobei die Berührschutzabdeckung (7) ausgebildet ist, beim Schwenken des Betätigungshebels (12, 13) den Rasthaken (10, 11) mitzuschwenken.

3. Steuergerät (1) nach Anspruch 1 oder 2,
**dadurch gekennzeichnet, dass**
die Berührschutzabdeckung (7) eine an die Berührschutzabdeckung (7) angeformte elastisch ausgebildete Dichtung (9) aufweist, welche ausgebildet ist, wenigstens einen Rand der Gehäuseöffnung (6) und den Gehäusedeckel (5) einander abzudichten.

4. Steuergerät (1) nach Anspruch 3,
**dadurch gekennzeichnet, dass**
die Dichtung (9) Silikongummi aufweist.

5. Steuergerät (1) nach Anspruch 3 oder 4,
**dadurch gekennzeichnet, dass**
die Dichtung (9) im Bereich eines Deckelrandes des Gehäusedeckels (5) über den Deckelrand hinausragt, so dass das Vorhandensein der Berührschutzabdeckung (7) von außen gesehen werden kann.

6. Steuergerät nach Anspruch 5,
**dadurch gekennzeichnet, dass**
die Dichtung eine Signalfarbe, insbesondere eine der Farben Rot, Gelb oder Orange aufweist.

7. Steuergerät (1) nach einem der vorhergehenden Ansprüche,
**dadurch gekennzeichnet, dass**
der Gehäusedeckel wenigstens einen Durchbruch oder eine Aussparung für eine Schraube aufweist, wobei das Gehäuse bevorzugt ein Gewinde, insbesondere ein Innengewinde für die Schraube aufweist, wobei das Innengewinde derart angeordnet ist, dass der Gehäusedeckel mit dem Gehäuse dicht verschraubt werden kann.

8. Steuergerät (1) nach einem der vorhergehenden Ansprüche,
**dadurch gekennzeichnet, dass**
die Berührschutzabdeckung (7) wenigstens einen Durchbruch (14, 15) zum Durchführen einer Tastspitze (35, 37) eines elektrischen Spannungsmessgerätes (34) aufweist.

9. Steuergerät (1) nach einem der vorhergehenden Ansprüche,
**dadurch gekennzeichnet, dass**
an die Berührschutzabdeckung (7) ein Halteelement (16, 17, 18, 19) angeformt ist, welches sich quer zu der Oberfläche in eine zum Vorsprungsbereich (20) entgegengesetzte Richtung erstreckt und welches hohlzylinderumfangsabschnittsförmig oder hohlzylinderförmig geformt ist und ausgebildet ist, einen Kopf einer Schraube (24, 25) zu umgreifen und gegen ein Lösen der Schraube (24, 25) festzuhalten.

10. Steuergerät (1) nach einem der vorhergehenden Ansprüche,
**dadurch gekennzeichnet, dass**
die Berührschutzabdeckung (7) aus faserverstärktem Kunststoff gebildet ist.

11. Steuergerät (1) nach Anspruch 10,
**dadurch gekennzeichnet, dass**
der Kunststoff der Berührschutzabdeckung (7) Poly-Butylen-Terephtalat aufweist.

12. Verfahren zum Absichern eines Steuergerätes (1) umfassend ein einen Hohlraum (4) umschließendes Gehäuse, umfassend die Schritte:
- kraftschlüssiges Verbinden einer Berührschutzabdeckung (7) mit einer Innenwand eines Gehäusedeckels (5);
- Verschließen einer Gehäuseöffnung (6) des Gehäuses (3) mit dem Gehäusedeckel (5), wobei die Berührschutzabdeckung (7) mit dem Gehäuse (3) oder einem mit dem Gehäuse (3) verbundenen Teil des Steuergeräts (1) verrastet, so dass die Berührschutzabdeckung (7) mit dem Gehäuse (3) oder Teil formschlüssig verbunden ist,
wobei eine Kraft zum Lösen der Verrastung der Berührschutzabdeckung (7) mit dem Gehäuse (3) größer ist als eine Kraft zum Trennen der Berührschutzabdeckung (7) von dem Gehäusedeckel (5).

13. Verfahren nach Anspruch 12,
bei dem beim Verschließen der Gehäuseöffnung (6) eine an die Berührschutzabdeckung (7) angeformte Dichtung (9) zwischen einem Öffnungsrand der Gehäuseöffnung (6) und dem Gehäusedeckel (5) eingeschlossen wird, so dass der Hohlraum (4) vor eindringender Feuchtigkeit geschützt ist.

## Claims

1. Control unit (1) for an electric vehicle or hybrid vehicle, having a housing (3) enclosing at least one cavity (4), wherein the housing (3) has a housing lid (5) and a housing opening (6), wherein the housing lid (5) is designed to close the housing opening (6), wherein the control unit (1) has an electrically insulating shock hazard protection cover (7), wherein the electrically insulating shock hazard protection cover (7) has at least one projection region (20) extending transversely with respect to a surface of the shock hazard protection cover (7), **characterized in that** the housing lid (5) has at least one receptacle (21) for the projection region (20), which receptacle is designed to securely hold the projection region (20) with a frictional fit, and the shock hazard protection cover (7) has at least one latching hook (10, 11), wherein the latching hook (10, 11) is designed to latch, with a form fit or additionally with a frictional fit, with the housing (3), wherein a force for releasing the latching of the shock hazard protection cover (7) with the housing (3) is greater than a force for separating the shock hazard protection cover (7) from the housing lid (5), such that the housing lid together with the shock hazard protection cover (7) can be connected to the housing (3), and the projection region (20) can be separated from the housing lid (5) when the housing lid (5) is opened, wherein the shock hazard protection cover (7) can remain latched to the housing (3).

2. Control unit (1) according to Claim 1,
**characterized in that**
an actuation lever (12, 13) is integrally formed on the shock hazard protection cover (7), which actuation lever extends in the direction of the lid (5), pointing away from the shock hazard protection cover (7), and the shock hazard protection cover (7) in the region of the actuation lever (12, 13) has a slit (33, 34), such that the actuation lever (12, 13) can be resiliently pivoted, wherein the shock hazard protection cover (7) is designed to also pivot the latching hook (10, 11) as the actuation lever (12, 13) is pivoted.

3. Control unit (1) according to Claim 1 or 2,
**characterized in that**
the shock hazard protection cover (7) has a resilient seal (9) seal formed integrally on the shock hazard protection cover (7), which seal is designed to seal at least an edge of the housing opening (6) and the housing lid (5) with respect to each other.

4. Control unit (1) according to Claim 3,
**characterized in that**
the seal (9) comprises silicone rubber.

5. Control unit (1) according to Claim 3 or 4,
**characterized in that**
the seal (9) projects in the region of a lid edge of the housing lid (5) beyond the lid edge, such that the presence of the shock hazard protection cover (7) can be seen from outside.

6. Control unit according to Claim 5,
**characterized in that**
the seal has a signal colour, in particular one of the colours red, yellow or orange.

7. Control unit (1) according to one of the preceding claims,
**characterized in that**
the housing lid has at least one aperture or a cutout for a screw, wherein the housing preferably has a thread, in particular an inner thread for the screw, wherein the inner thread is arranged in such a way that the housing lid can be tightly screwed to the housing.

8. Control unit (1) according to one of the preceding claims,
**characterized in that**
the shock hazard protection cover (7) has at least one aperture (14, 15) for passing through a probe tip (35, 37) of an electric voltmeter (34).

9. Control unit (1) according to one of the preceding claims,
**characterized in that**
a retaining element (16, 17, 18, 19) is integrally formed on the shock hazard protection cover (7), which retaining element extends transversely with respect to the surface in a direction opposite the projection region (20) and which is shaped in the manner of a hollow cylinder portion or hollow-cylindrically and is designed to engage around a head of a screw (24, 25) and to securely hold the screw (24, 25) against detachment.

10. Control unit (1) according to one of the preceding claims,
**characterized in that**
the shock hazard protection cover (7) is formed from fiber-reinforced plastic.

11. Control unit (1) according to Claim 10,
**characterized in that**
the plastic of the shock hazard protection cover (7) comprises polybutylene terephthalate.

12. Method for making safe a control unit (1) comprising a housing enclosing a cavity (4), said method comprising the steps of:
- frictionally connecting a shock hazard protection cover (7) to an inner wall of a housing lid (5);
- closing a housing opening (6) of the housing (3) with the housing lid (5), wherein the shock hazard protection cover (5) latches with the housing (3) or part of the control unit (1) connected to the housing (3), such that the shock hazard protection cover (7) interlocks with the housing (3) or part, wherein a force for releasing the latching of the shock hazard protection cover (7) with the housing (3) is greater than a force for separating the shock hazard protection cover (7) from the housing lid (5) .

13. Method according to Claim 12,
in which a seal (9) formed integrally on the shock hazard protection cover (7) is trapped between an opening edge of the housing opening (6) and the housing lid (5) as the housing opening (6) is closed, such that the cavity (4) is protected against infiltrating moisture.

## Revendications

1. Unité de commande (1) destinée à un véhicule électrique ou à un véhicule hybride, comprenant un boîtier (3) qui entoure au moins un espace creux (4), dans lequel le boîtier (3) possède un couvercle de boîtier (5) et un orifice de boîtier (6), dans lequel le couvercle de boîtier (5) est conçu pour fermer l'orifice de boîtier (6), dans lequel l'unité de commande (1) possède un capotage (7) de protection contre les contacts accidentels électriquement isolant,
dans lequel le capotage (7) de protection contre les contacts accidentels électriquement isolant comporte au moins une zone en saillie (20) qui s'étend transversalement par rapport à une surface du capotage (7) de protection contre les contacts accidentels, **caractérisé en ce que** le couvercle de boîtier (5) comporte au moins un évidement (21) destiné à la zone en saillie (20), qui est conçu pour retenir la zone en saillie (20) par complémentarité de force et **en ce que** le capotage (7) de protection contre les contacts accidentels comporte au moins un crochet d'encliquetage (10, 11), dans lequel le crochet d'encliquetage (10, 11) est conçu pour s'encliqueter par complémentarité de forme, ou également par complémentarité de force, avec le boîtier (3), dans lequel une force destinée à libérer l'encliquetage du capotage (7) de protection contre les contacts accidentels avec le boîtier (3) est supérieure à une force destinée à séparer le capotage (7) de protection contre les contacts accidentels du couvercle de boîtier (5), de manière à ce que le couvercle de boîtier puisse être relié au boîtier (3) conjointement avec le capotage (7) de protection contre les contacts accidentels et à ce que la partie en saillie (20) puisse être séparée du couvercle de boîtier (5) lorsque le couvercle de boîtier (5) est ouvert, dans lequel le capotage (7) de protection contre les contacts accidentels peut rester encliqueté avec le boîtier (3).

2. Unité de commande (1) selon la revendication 1, **caractérisée en ce qu'**un levier d'actionnement (12, 13) est formé sur le capotage (7) de protection contre les contacts accidentels, qui s'étend dans la direction du capot de boîtier (5) en s'écartant du capotage (7) de protection contre les contacts accidentels et le capotage (7) de protection contre les contacts accidentels présente une fente (33, 34) dans la zone du levier d'actionnement (12, 13), de manière à ce que le levier d'actionnement (12, 13) puisse pivoter élastiquement, dans lequel le capotage (7) de protection contre les contacts accidentels est conçu pour faire pivoter le crochet d'encliquetage (10, 11) lorsque le levier d'actionnement (12, 13) est amené à pivoter.

3. Unité de commande (1) selon la revendication 1 ou 2,
**caractérisé en ce que** le capotage (7) de protection contre les contacts accidentels comporte un joint (9) réalisé sous forme élastique qui est formé sur le capotage (7) de protection contre les contacts accidentels et qui est destiné à rendre étanche entre eux au moins un bord de l'orifice de boîtier (6) et le couvercle de boîtier (5).

4. Unité de commande (1) selon la revendication 3, **caractérisée en ce que** le joint (9) est en caoutchouc silicone.

5. Unité de commande (1) selon la revendication 3 ou 4,
**caractérisée en ce que** le joint (9) dépasse du bord du couvercle dans la zone d'un bord de couvercle du couvercle de boîtier (5), de manière à ce que la présence du capotage (7) de protection contre les contacts accidentels soit visible de l'extérieur.

6. Unité de commande selon la revendication 5, **caractérisée en ce que** le joint présente une couleur de signalisation, en particulier l'une des couleurs rouge, jaune ou orange.

7. Unité de commande (1) selon l'une des revendications précédentes,
**caractérisée en ce que** le couvercle de boîtier comporte au moins une traversée ou un évidement destiné à une vis, dans lequel le boîtier présente de préférence un filetage, en particulier un filetage intérieur destiné à la vis, dans lequel le filetage intérieur est disposé de manière à ce que le couvercle de boîtier puisse être vissé hermétiquement sur le boîtier.

8. Unité de commande (1) selon l'une des revendications précédentes,
**caractérisée en ce que** le capotage (7) de protection contre les contacts accidentels comporte au moins une traversée (14, 15) pour le passage d'une pointe de sonde (35, 37) d'une unité de mesure de tension électrique (34) .

9. Unité de commande (1) selon l'une des revendications précédentes,
**caractérisée en ce qu'**un élément de retenue (16, 17, 18, 19) qui s'étend transversalement par rapport à la surface dans une direction opposée à la zone en saillie (20) et qui est réalisé sous la forme d'une section circonférentielle cylindrique creuse ou sous la forme d'un cylindre creux, est formé sur le capotage (7) de protection contre les contacts accidentels et est conçu pour s'engager sur une tête de vis (24, 25) et empêcher un desserrage de la vis (24, 25).

10. Unité de commande (1) selon l'une des revendications précédentes,
**caractérisée en ce que** le capotage (7) de protection contre les contacts accidentels est réalisé en matière plastique renforcée par des fibres.

11. Unité de commande (1) selon la revendication 10, **caractérisée en ce que** la matière plastique du capotage (7) de protection contre les contacts accidentels comprend du polytéréphtalate de butylène.

12. Procédé de fixation d'une unité de commande (1) comprenant un boîtier qui entoure un espace creux (4), comprenant les étapes consistant à :
- lier par complémentarité de force un capotage (7) de protection contre les contacts accidentels à une paroi intérieure d'un couvercle de boîtier (5) ;
- fermer un orifice de boîtier (6) du boîtier (3) avec le couvercle de boîtier (5), dans lequel le capotage (7) de protection contre les contacts accidentels s'encliquette avec le boîtier (3) ou une partie de l'unité de commande (1) reliée au boîtier (3) de manière à ce que le capotage (7) de protection contre les contacts accidentels soit relié par complémentarité de forme au boîtier (3) ou à une partie de celui-ci,
dans lequel une force destinée à libérer l'encliquetage du capotage (7) de protection contre les contacts accidentels avec le boîtier (3) est supérieure à une force destinée à séparer le capotage (7) de protection contre les contacts accidentels du couvercle de boîtier (5) .

13. Procédé selon la revendication 12,
dans lequel, lorsque l'orifice de boîtier (6) est fermé, un joint (9) formé sur le capotage (7) de protection contre les contacts accidentels est enfermé entre un bord d'orifice de l'orifice de boîtier (6) et le couvercle de boîtier (5) de manière à ce que l'espace creux (4) soit protégée contre l'humidité pouvant y pénétrer.
